# EUROPEAN PATENT SPECIFICATION

(11) **EP 4 625 492 B1**
(45) Date of publication and mention of the grant of the patent: **30.09.2026**
(21) Application number: 25164980.2
(22) Date of filing: 20.03.2025
(51) Int. Cl.: H02M 7/00, H10W 72/50, H10W 90/00, H02M 1/32, H10W 40/25, H10W 70/60, H10W 40/00, H10W 70/65

(54) **SEMICONDUCTOR MODULE**
HALBLEITERMODUL
MODULE SEMI-CONDUCTEUR

(30) Priority: 28.03.2024 JP 2024052721
(43) Date of publication of application: 01.10.2025
(73) Proprietor: Shindengen Electric Manufacturing Co., Ltd., Tokyo 100-0004 (JP)
(72) Inventor: MORINAGA, Yuji, Saitama, 3518503 (JP); YUGUCHI, Junya, Saitama, 3518503 (JP)
(74) Representative: Liesegang, Eva

(56) References cited:
- CN-A- 103 855 914
- US-A1- 2023 142 930
- US-A1- 2023 363 097

## Description

### [Technical Field]

The present invention relates to a semiconductor module.

### [Background Art]

Conventionally, in a technical field of a semiconductor module, a semiconductor module that includes a temperature detection element (for example, a thermistor) has been known (see non-patent literature 1)

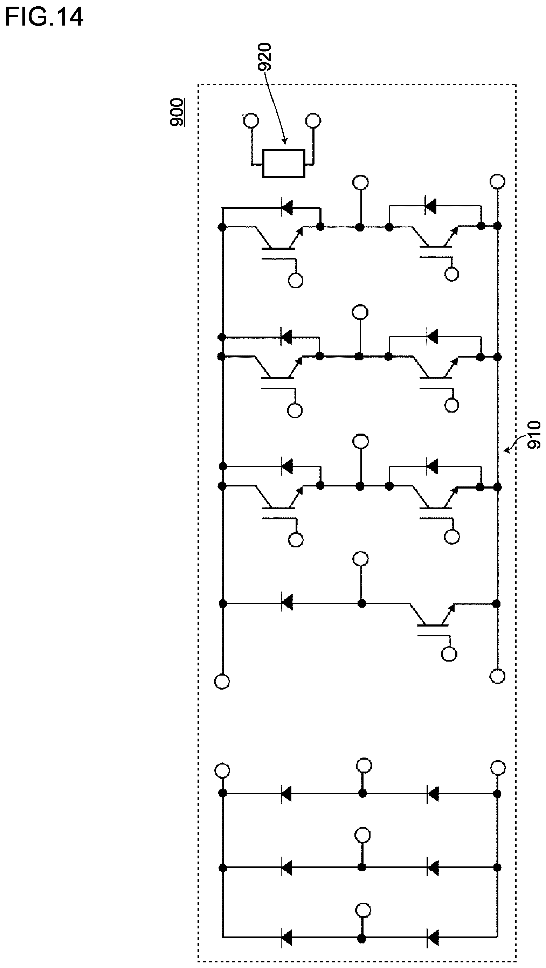

As illustrated in Fig. 14, a conventional semiconductor module 900 is a semiconductor module that includes an inverter circuit 910. The semiconductor module 900 further includes a thermistor 920 on a peripheral edge thereof. According to the conventional semiconductor module 900, it is possible to detect a temperature in the semiconductor module 900 by the thermistor 920.

### [Prior Art Literature]

US 2023/142930 A1 discloses: A power module is provided with a substrate, power devices, and a housing. The power devices are mounted on device pads of the substrate and arranged to provide a power circuit having a first input, a second input, and at least one output. First and second power terminals provide first and second inputs for the power circuit. At least one output power terminal provides at least one output. The housing encompasses the substrate, the power devices, and portions of the first and second input power terminals as well as the at least one output power terminal. The first and second input power terminals extend out of a first side of the housing, and the at least one output power terminal extends out of a second side of the housing, the first side being opposite the second side.
US 2023/363097 A1 discloses: A power module is provided with a substrate, power devices, and a housing. The power devices are mounted on device pads of the substrate and arranged to provide a power circuit having a first input, a second input, and at least one output. First and second power terminals provide first and second inputs for the power circuit. At least one output power terminal provides at least one output. The housing encompasses the substrate, the power devices, and portions of the first and second input power terminals as well as the at least one output power terminal.
CN 103855914 A discloses a power supply system, a power module in the power supply system and a manufacturing method for the power module. The power module comprises a first common pin, a second common pin, a first bridge arm and a second bridge arm. The first common pin and the second common pin are symmetrically arranged on one side of a substrate. The first bridge arm comprises a first semiconductor device and a second semiconductor device, wherein the first semiconductor device and the second semiconductor device are mutually connected through the first common pin and adjacently arranged. The second bridge arm comprises a third semiconductor device and a fourth semiconductor device, wherein the third semiconductor device and the fourth semiconductor device are mutually connected through the second common pin and adjacently arranged. The first semiconductor device and the third semiconductor device are symmetrically arranged, and the second semiconductor device and the fourth semiconductor device are symmetrically arranged.

### [Non-patent literature]

[Non-patent Literature 1] IGBT module T series CM35MXUA-24T datasheet, [online], Mitsubishi Electric Corporation [retrieved on 2024, March 1st], internet, <URL:https://www.mitsubishielectric.co.jp/semicond uctors/powerdevices/datasheets/igbt/t_series/cm35m xua-24t_e.pdf>

### [Summary of Invention]

### [Technical Problem]

However, in the technical field of a semiconductor module, there has been a demand for the more accurate temperature detection of the inside of a semiconductor module. For example, a semiconductor module that uses a wideband gap semiconductor element (for example, an SiC semiconductor element) is used with large electric power compared to a semiconductor module that uses a silicon semiconductor element. Accordingly, such a semiconductor module generates a large heat and hence, there is a tendency that an operation temperature of the semiconductor module becomes high. Accordingly, in a semiconductor module that uses a wideband gap semiconductor module, it is necessary to more accurately perform the temperature detection of the semiconductor module. A temperature control of the semiconductor module is a universally important technique in the technical field of the semiconductor module. Accordingly, a semiconductor module that uses a silicon semiconductor element can receive a benefit acquired by performing the temperature detection more accurately.

The present invention has been made in view of the above-mentioned circumstances, and it is an object of the present invention to provide a semiconductor module capable of more accurately performing the temperature detection compared to a prior art.

### [Solution to Problem]

[1] A semiconductor module according to the present invention is a semiconductor module that includes: first to fourth semiconductor elements; a plurality of wiring patterns; a first power source terminal; a second power source terminal; a first intermediate point terminal and a second intermediate point terminal. A full bridge circuit is formed in the semiconductor module where the first semiconductor element and the third semiconductor element are disposed at a high side and the second semiconductor element and the fourth semiconductor element are disposed at a low side therein. The semiconductor module further includes: a temperature detection element having a first temperature detection electrode and a second temperature detection electrode; a first temperature detection wiring pattern that is connected with the first temperature detection electrode; a first temperature detection terminal that is a terminal to be connected with the temperature detection circuit and is connected with the first temperature detection wiring pattern; a second temperature detection wiring pattern that is connected with the second temperature detection electrode; and a second temperature detection terminal that is a terminal to be connected with a ground or a control system power source, and connected with the second temperature detection wiring pattern. A current path that is formed when both the first semiconductor element and the fourth semiconductor element are turned on and includes a first current path that extends from the first power source terminal to the first intermediate point terminal and a second current path that extends from the second intermediate point terminal to the second power source terminal is set as a first switching path, and a current path that is formed when both the third semiconductor element and the second semiconductor element are turned on and includes a third current path that extends from the first power source terminal to the second intermediate point terminal and the fourth current path that extends from the first intermediate point terminal to the second power source terminal is set as a second switching path. The temperature detection element is disposed in a region surrounded by the first switching path and the second switching path. With such a configuration, the semiconductor module can reduce noises caused by a parasitic capacitance between a wiring pattern that constitutes a common portion of the first current path and the fourth current path and the first temperature detection wiring pattern, and a parasitic capacitance between a wiring pattern that constitutes a common portion of the second current path and the third current path and the first temperature detection wiring pattern.
[2] In the semiconductor module according to one embodiment of the present invention, it is desired that the plurality of wiring patterns include: a first wiring pattern on which the first semiconductor element is mounted and with which the first power source terminal is connected; a second wiring pattern on which the second semiconductor element is mounted and with which the first intermediate point terminal is connected; a third wiring pattern on which the third semiconductor element is mounted and with which the first power source terminal is connected; and a fourth wiring pattern on which the fourth semiconductor element is mounted and with which the second intermediate point terminal is connected, and the first temperature detection wiring pattern, when the semiconductor module is viewed in a plan view, is disposed between the second wiring pattern and the fourth wiring pattern.
[3] In the semiconductor module according to one embodiment of the present invention (the semiconductor module in the above-mentioned [2]), it is desired that a distance between the first temperature detection wiring pattern and the second wiring pattern is equal to a distance between the first temperature detection wiring pattern and the fourth wiring pattern.
[4] In the semiconductor module according to one embodiment of the present invention (the semiconductor module in the above-mentioned [2]), it is desired that the second power source terminal is a terminal to be connected with the ground, the plurality of wiring patterns further include a fifth wiring pattern with which the second power source terminal is connected, and the fifth wiring pattern includes an extension portion that extends in a direction that the first temperature detection wiring pattern is disposed.
[5] In the semiconductor module according to one embodiment of the present invention (the semiconductor module in the above-mentioned [2]), it is desired that the second temperature detection wiring pattern is disposed between the first temperature detection wiring pattern and the second wiring pattern or between the first temperature detection wiring pattern and the fourth wiring pattern, and the semiconductor module further includes a capacitive coupling reducing wiring pattern that is disposed on the side where the second temperature detection wiring pattern is not disposed out of between the first temperature detection wiring pattern and the second wiring pattern and between the first temperature detection wiring pattern and the fourth wiring pattern.
[6] In the semiconductor module according to one embodiment of the present invention (the semiconductor module in the above-mentioned [5]), it is desired that the capacitive coupling reducing wiring pattern is a pattern that is connected with the ground.
[7] In the semiconductor module according to one embodiment of the present invention (the semiconductor module in the above-mentioned [6]), it is desired that the second power source terminal is a terminal to be connected with the ground, the plurality of wiring patterns further include a fifth wiring pattern with which the second power source terminal is connected, and the capacitive coupling reducing wiring pattern is connected with the fifth wiring pattern.
[8] In the semiconductor module according to the present invention (the semiconductor module in the above-mentioned [2]), it is desired that when the semiconductor module is viewed in a plan view, the first temperature detection wiring pattern and the first temperature detection terminal are disposed at a position where the first temperature detection wiring pattern and the first temperature detection terminal overlap with a predetermined axis of symmetry, at least a portion of the first temperature detection terminal and the first temperature detection wiring pattern have a shape where the portion and the first temperature detection wiring pattern are in line symmetry with reference to the predetermined axis of symmetry, and the first to fourth semiconductor elements, the first to fourth wiring patterns, the first power source terminal, the second power source terminals, the first intermediate point terminal and the second intermediate point terminal that are constitutional elements of the semiconductor module are in line symmetry with respect to the predetermined axis of symmetry.

### [Advantageous Effects of the Present Invention]

In the semiconductor module according to the present invention, the temperature detection element is disposed in the region surrounded by the first switching path and the second switching path in the full bridge circuit and is disposed in the vicinity of a heat generation source. With such a configuration, the semiconductor module according to the present invention becomes a semiconductor module that can accurately perform the temperature detection compared to the prior art.

Further, the semiconductor module according to the present invention is configured to reduce noises caused by "a parasitic capacitance between the wiring pattern that constitutes the common portion of the first current path and the fourth current path and the first temperature detection wiring pattern" and "a parasitic capacitance between the wiring pattern that constitutes the common portion of the second current path and the third current path and the first temperature detection wiring pattern". With such a configuration, according to the semiconductor module of the present invention, a parasitic capacitance between the first temperature detection wiring pattern and the first current path on the first switching path, and a parasitic capacitance between the first temperature detection wiring pattern and the second current path on the first switching path are balanced and hence, noises that are generated at the time of switching can be reduced. Further, according to the semiconductor module of the present invention, a parasitic capacitance between the first temperature detection wiring pattern and the third current path on the second switching path, and a parasitic capacitance between the first temperature detection wiring pattern and the fourth current path on the second switching path are balanced and hence, noises generated at the time of switching can be reduced. As a result, the semiconductor module according to the present invention becomes a semiconductor module that can make an output voltage of the temperature detection element stable thus capable of performing the temperature detection in a more stable manner.

### [Brief Description of Drawings]

Fig. 1 is a plan view of the internal configuration of a semiconductor module 1 according to an embodiment 1. In Fig. 1, to illustrate the internal configuration of the semiconductor module 1, only an outer edge is illustrated with respect to a sealing material M, and portions of sealing material M that overlap with other constitutional elements are not illustrated. The same goes for plan views of other internal configurations, an explanatory view of a current path, and a main part enlarged view described later.
Fig. 2 is a main part enlarged view illustrating a main part in Fig. 1 in an enlarged manner.
Fig. 3 is an equivalent circuit diagram of the semiconductor module 1 according to the embodiment 1.

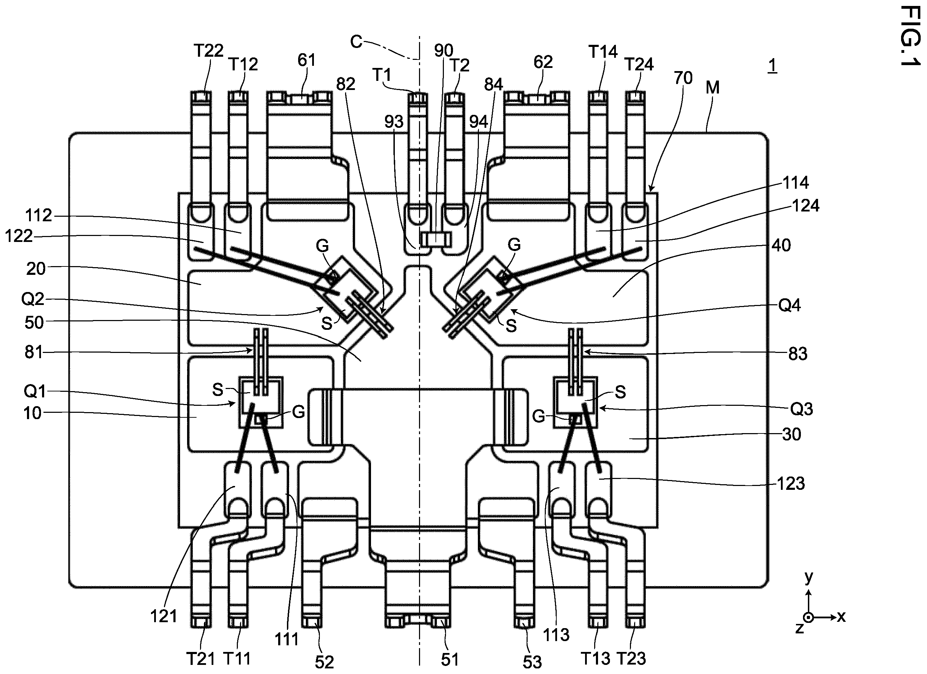

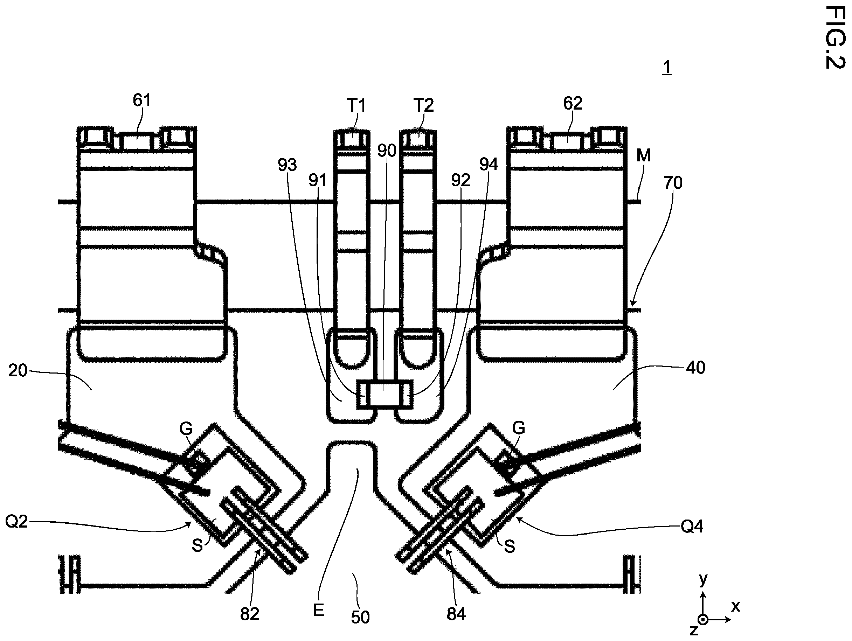

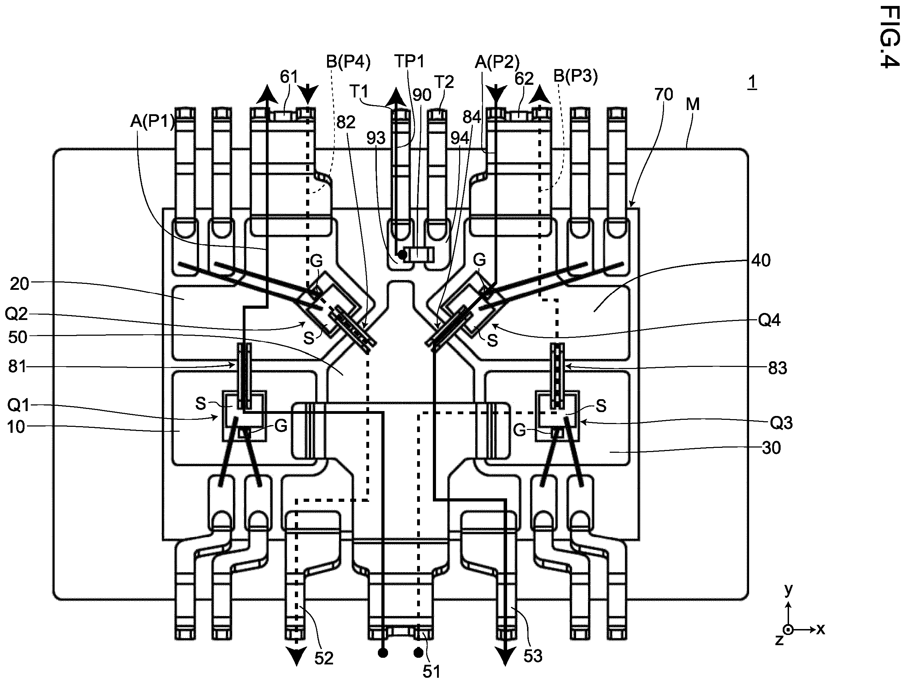

Fig. 4 is an explanatory view of current paths of the semiconductor module 1 according to the embodiment 1. Fig. 4 is a view obtained by adding the current path to the semiconductor module 1 illustrated in Fig. 1, and the configuration of the semiconductor module illustrated in Fig. 4 is substantially equal to the corresponding configuration in Fig. 1. However, in Fig. 4, with respect to symbols that indicate respective constitutional elements illustrated in Fig. 2, some symbols are omitted, and mainly, the symbols of constitutional elements necessary for describing the current path are described.
Fig. 5 is a plan view of the internal configuration of a semiconductor module 2 according to an embodiment 2.
Fig. 6 is a main part enlarged view that enlarges a main part in Fig. 5.
Fig. 7 is a plan view of the internal configuration of a semiconductor module 3 according to an embodiment 3.
Fig. 8 is a main part enlarged view that enlarges a main part in Fig. 7.
Fig. 9 is a plan view of the internal configuration of a semiconductor module 4 according to an embodiment 4.
Fig. 10 is a main part enlarged view that enlarges a main part in Fig. 9.
Fig. 11 is a plan view of the internal configuration of a semiconductor module 1A according to a comparison example.
Fig. 12 is an explanatory view of current paths of the semiconductor module 1A according to the comparison example.

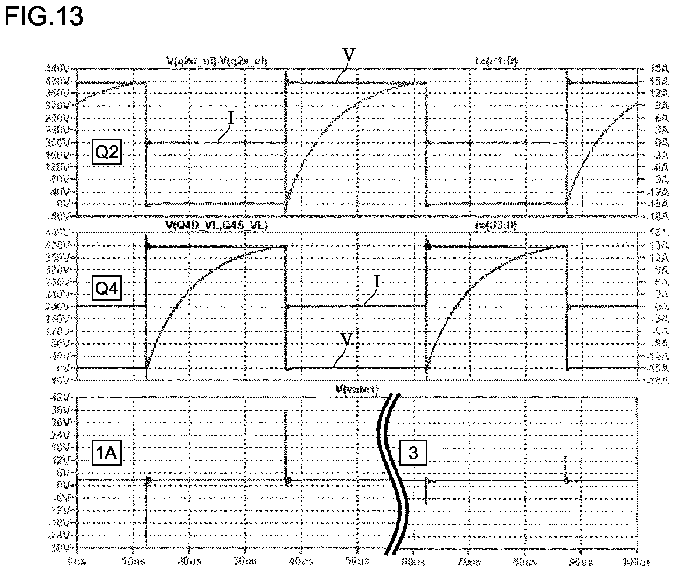

Fig. 13 is a graph illustrating a noise characteristic of the semiconductor module 3 according to the embodiment 3 and a noise characteristic of the semiconductor module 1A according to the comparison example. In Fig. 13, a graph at an upper stage, a graph at an intermediate stage, and a graph at a lower stage are illustrated in parallel in a vertical direction such that lateral axes (times) of the respective graphs are aligned with each other. A graph at the upper stage (a graph indicated by "Q2") is a graph indicating a change in voltage V and a change in current I of a second semiconductor element Q2 when a full bridge circuit is operated. A graph at the intermediate stage (a graph indicated by "Q4") is a graph indicating a change in voltage V and a change in current I of a fourth semiconductor element Q4 when a full bridge circuit 100 is operated. A graph at the lower stage (a graph indicated by "1A" and "1") is a graph indicating a change in a voltage of a first temperature detection path TP1 when the full bridge circuit is operated. The graph at the lower stage is divided into two graphs. The graph on a side where the indication "1A" exists is a graph indicating a change in voltage in the semiconductor module 1A according to the comparison example. The graph on a side where the indication "3" exists is a graph indicating a change in voltage in the semiconductor module 3 according to the embodiment 3. Numerical values of voltages are described at the left ends of the respective graphs, and numerical values of the currents are indicated at the right ends of the graph at the upper stage and the graph at the lower stage.
Fig. 14 is an equivalent circuit diagram of a conventional semiconductor module 900.

### [Description of Embodiments]

Hereinafter, a semiconductor module according to the present invention is described based on respective embodiments illustrated in the drawings. In the respective embodiments described hereinafter, with respect to constitutional elements that have completely the same functions or substantially the same function, even when the constitutional elements differ from each other more or less in shape or the like, there may be a case that the same symbols are used over the embodiments, and the repeated explanation is omitted. The embodiments described hereinafter are not intended to limit the present invention called for in claims. Further, it is not always the case that all of various elements described in the embodiments and combinations of these elements are indispensable as a means to solve the problems of the present invention.

### [Embodiment 1]

### 1.configuration of semiconductor module 1

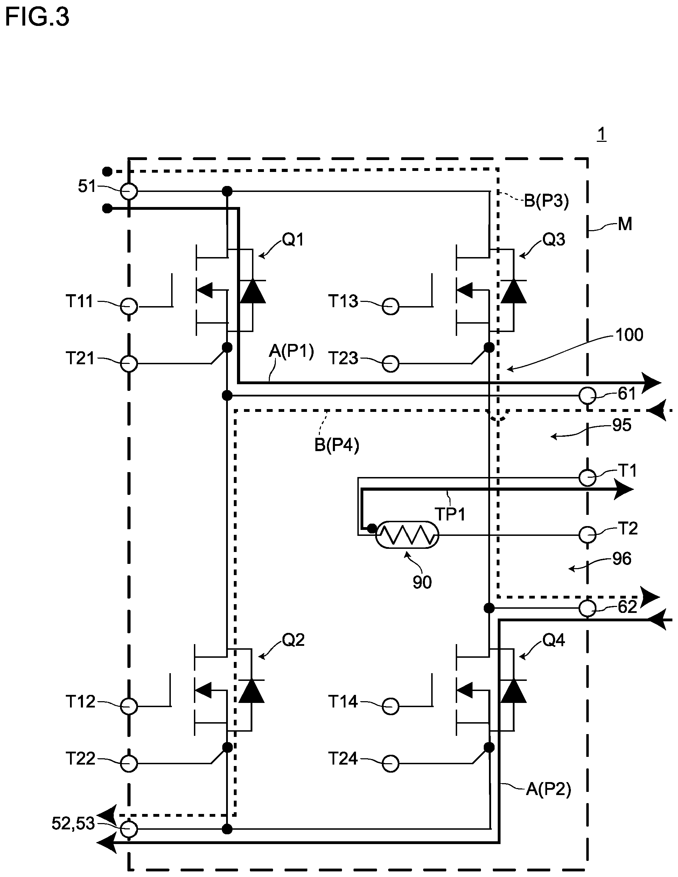

As illustrated in Fig. 1 and Fig. 2, the semiconductor module 1 according to the embodiment 1 includes: first to fourth semiconductor elements Q1 to Q4; a plurality of wiring patterns; a first power source terminal 51; second power source terminals 52, 53; a first intermediate point terminal 61; and a second intermediate point terminal 62. The plurality of wiring patterns include first to fifth wiring patterns 10 to 50 through which a main current (a large current) flows. As the semiconductor module 1, a full bridge circuit 100 is constituted such that the first semiconductor element Q1 and the third semiconductor element Q3 are arranged at a high side, and the second semiconductor element Q2 and the fourth semiconductor element Q4 are arranged at a low side (see Fig. 3). The full bridge circuit 100 is described later.

The semiconductor module 1 further includes: a board 70; a temperature detection element 90; other wiring patterns; other terminals; and a sealing material M. The other wiring patterns include: first and second temperature detection wiring pattern 93, 94; first to fourth control wiring patterns 111 to 114; and first to fourth detection wiring patterns 121 to 124. Further, the other terminals include: first and second temperature detection terminals T1, T2; first to fourth control terminals T11 to T14; and first to fourth detection terminals T21 to T24.

Hereinafter, the above-mentioned respective constitutional elements are described.

In the semiconductor module 1, the first to fourth semiconductor elements Q1 to Q4 are metal oxide semiconductor field effect transistors (MOSFETs). The first to fourth semiconductor elements Q1 to Q4 each have a source electrode S, a drain electrode D, and a gate electrode G.

In a case where the first to fourth semiconductor elements Q1 to Q4 are vertical transistor elements, the drain electrode D exists on a surface of each of the first to fourth semiconductor elements Q1 to Q4 on a first to fourth wiring pattern 10 to 40 side. In the semiconductor module 1, a case is illustrated where the first to fourth semiconductor elements Q1 to Q4 are vertical transistor elements. Accordingly, when the semiconductor module 1 is viewed in a plan view as in the case of Fig. 1, the drain electrodes D are not viewed. Accordingly, a symbol "D" that indicates the drain electrodes is not illustrated in the respective drawings. Further, the gate electrode G exists on a surface of each of the first to fourth semiconductor elements Q1 to Q4 on a source electrode S side.

The first to fourth semiconductor elements Q1 to Q4 are suitably changeable within a scope where the gist of the present invention is not changed. The first to fourth semiconductor elements Q1 to Q4 are not limited to MOSFETs, and may be other semiconductor elements such as insulated gate bipolar transistors (IGBTs) or the like.

Further, the first to fourth semiconductor elements Q1 to Q4 may be, for example, lateral transistor elements (for example, GaN-HEMT formed using a GaN-on-Si material, compound-semiconductor transistor elements or the like made of a Ga₂O₃-on-Si material). Further, the first to fourth semiconductor elements Q1 to Q4 are not limited to transistor elements, and transistor elements may have modified configurations where the transistor element is suitably replaced with a diode element corresponding to circuit application. By adopting such modified configurations, the present invention becomes suitably applicable to a totem-pole-type bridgeless PFC circuit and the like.

The source electrode S of the first semiconductor element Q1 is connected with the second wiring pattern 20 via a first connection member 81. As the first connection member 81 and second to fourth connection members 82 to 84 described later, for example, a connection member made of an aluminum wire can be used. Further, the drain electrode D of the first semiconductor element Q1 is connected with the first wiring pattern 10.

The source electrode S of the second semiconductor element Q2 is connected with the fifth wiring pattern 50 via the second connection member 82. The drain electrode D of the second semiconductor element Q2 is connected with the second wiring pattern 20.

The source electrode S of the third semiconductor element Q3 is connected with the fourth wiring pattern 40 via the third connection member 83. Further, the drain electrode D of the third semiconductor element Q3 is connected with the third wiring pattern 30.

The source electrode S of the fourth semiconductor element Q4 is connected with the fifth wiring pattern 50 via the fourth connection member 84. Further, the drain electrode D of the fourth semiconductor element Q4 is connected with the fourth wiring pattern 40.

The first to fifth wiring patterns 10 to 50 in the semiconductor module 1 are each made of an electrically conductive material disposed or formed on a base of the board 70. The other wiring patterns described later are substantially equal to the first to fifth wiring patterns 10 to 50 with respect to a point that the wiring patterns are made of an electrically conductive material disposed or formed on the base of the board 70.

With respect to the semiconductor module 1, as the board 70, a direct copper bonding (DCB) board formed by directly bonding metal (copper) to a base made of ceramic (alumina, aluminum nitride, silicon nitride or the like) can be suitably used.

The board in the semiconductor module according to the present invention is not limited to the DCB board. As the board, other ceramic boards such as an active metal brazing (AMB) board, a metal base board having a copper base or an aluminum base and the like can be also used. Further, as a material for forming the plurality of wiring patterns, metal other than copper (for example, aluminum) can be also used.

The first semiconductor element Q1 is mounted on the first wiring pattern 10, and the first power source terminal 51 is connected with the first wiring pattern 10. The second semiconductor element Q2 is mounted on the second wiring pattern 20, and a first intermediate point terminal 61 is connected with the second wiring pattern 20. The third semiconductor element Q3 is mounted on the third wiring pattern 30, and the first power source terminal 51 is connected with the third wiring pattern 30. The fourth semiconductor element Q4 is mounted on the fourth wiring pattern 40, and a second intermediate point terminal 62 is connected with the fourth wiring pattern 40. The second power source terminals 52, 53 are connected with the fifth wiring pattern 50.

The fifth wiring pattern 50 has an extension portion E that extends in a direction that the first temperature detection wiring pattern 93 is disposed.

The first power source terminal 51 and the second power source terminals 52, 53 are terminals for supplying electricity to a full bridge circuit. In the semiconductor module 1, the first power source terminal 51 assumes a current input side (high voltage side), and the second power source terminal 52 assumes a current output side (ground side) .

The first power source terminal 51 is a member having an approximately T shape where an inner lead portion (a portion existing in a sealing material M) is branched. The first power source terminal 51 strides over the fifth wiring pattern 50 in a noncontact manner, and is connected with the first wiring pattern 10 and the third wiring pattern 30.

The second power source terminals 52, 53 are respectively connected with the fifth wiring pattern 50. The second power source terminals 52, 53 are disposed so as to sandwich the first power source terminal 51 therebetween. As described above, the second power source terminal 52, 53 are terminals to be connected with the ground (not illustrated in the drawing).

The first intermediate point terminal 61 and the second intermediate point terminal 62 are terminals with which a load not illustrated in the drawing is connected. The first intermediate point terminal 61 is connected with the second wiring pattern 20, and the second intermediate point terminal 62 is connected with the fourth wiring pattern 40.

The temperature detection element 90 includes a first temperature detection electrode 91 and a second temperature detection electrode 92, and is disposed in a region surrounded by a first switching path A and a second switching path B. The first and second switching paths A, B are described in paragraphs relating to the full bridge circuit 100 and the current path described later. "Temperature detection element" in the present invention means an element that changes an electric characteristic (for example, resistance) generated by a change in temperature. As the temperature detection element 90, a thermistor can be preferably used.

The first temperature detection pattern 93 is connected with the first temperature detection electrode 91. The second temperature detection wiring pattern 94 is connected with the second temperature detection electrode 93. In the semiconductor module 1, the second temperature detection wiring pattern 94 is disposed between the first temperature detection wiring pattern 93 and the fourth wiring pattern 40.

The semiconductor module 1 is configured such that noises generated by a parasitic capacitance between a wiring pattern that constitutes a common portion of the first current path P1 and the fourth current path P4 and the first temperature detection wiring pattern 93, and a parasitic capacitance between a wiring pattern that constitutes a common portion of the second current path P2 and the third current path P3 and the first temperature detection wiring pattern 93 are reduced. To reduce two parasitic capacitances described above, "balance between two parasitic capacitances" and "the reduction of parasitic capacitance itself" become important.

As described later, in the semiconductor module 1, "the wiring pattern that constitutes the common portion of the first current path P1 and the fourth current path P4" is the second wiring pattern 20, and "the wiring pattern that constitutes the common portion of the second current path P2 and the third current path P3" forms the fourth wiring pattern. In the semiconductor module 1, the first temperature detection wiring pattern 93 is disposed between the second wiring pattern 20 and the fourth wiring pattern 40 as viewed in a plan view of the semiconductor module 1.

Further, in the semiconductor module 1, a distance between the first temperature detection wiring pattern 93 and the second wiring pattern 20 is equal to a distance between the first temperature detection wiring pattern 93 and the fourth wiring pattern 40. In this specification, "distances are equal" means that distances (shortest distances) in a design stage are equal. Accordingly, even in a case where the difference exists between two above-mentioned distances in an actual product, provided that the difference is generated by a phenomenon not intended such as an error, it is evaluated that substantially "the distances are equal".

The first temperature detection terminal T1 is a terminal to be connected with a temperature detection circuit (not illustrated in the drawing), and is connected with a first temperature detection wiring pattern 93. In this specification, "temperature detection circuit" means a circuit that is formed including a temperature detection element, and can detect temperature based on a change in electric characteristic in the temperature detection element.

The second temperature detection terminal T2 is a terminal to be connected with a ground or a control system power source (not illustrated in the drawing), and is connected with the second temperature detection wiring pattern 94. In this specification, "control system power source" means a power source device that supplies electricity for driving the temperature detection circuit. The control-system power source is a power source device different from a power source that supplies electricity to the first and second power source terminals (main power source). The control-based power source in this specification may also supply power to circuits and devices other than the temperature detection circuit.

The first to fourth control wiring patterns 111 to 114 are connected with the respective gate electrodes G of the first to fourth semiconductor elements Q1 to Q4 via connecting members such as aluminum wires or the like. Further, the first to fourth control wiring patterns 111 to 114 are connected with the first to fourth control terminals T11 to T14 respectively corresponding to the first to fourth control wiring patterns 111 to 114. Accordingly, the gate electrodes G of the first to fourth semiconductor elements Q1 to Q4 are respectively connected with the first to fourth control terminals T11 to T14.

The first to fourth detection wiring patterns 121 to 124 are connected with the respective source electrodes S of the first to fourth semiconductor elements Q1 to Q4 via connecting members such as aluminum wires respectively. Further, the first to fourth detection wiring patterns 121 to 124 are connected with the first to fourth temperature detection terminals T21 to T24 respectively corresponding to the first to fourth detection wiring patterns 121 to 124. Accordingly, the source electrodes S of the first to fourth semiconductor elements Q1 to Q4 are respectively connected with the first to fourth detection terminals T21 to T24.

The sealing material M seals the first to fourth semiconductor elements Q1 to Q4, the plurality of wiring patterns and temperature detection terminals 90. The sealing material M also seals respective inner lead portions of the first power source terminal 51, the second power source terminals 52, 53, the first intermediate point terminal 61, the second intermediate point terminal 62, the first temperature detection terminal T1 and the second temperature detection terminal T2. The sealing material M is made of a resin, for example.

In this specification, the shapes and the arrangements of the constitutional elements in the semiconductor module 1 are described. When the semiconductor module 1 is viewed in a plan view, the first temperature detection wiring pattern 93 and the first temperature detection terminal T1 are arranged at the position where these overlap with a predetermined axis of symmetry C. Further, at least a portion of the first temperature detection terminal T1 and the first temperature detection wiring pattern 93 have shapes in line symmetry with respect to the predetermined axis of symmetry C. The entirety of the first temperature detection terminal T1 in the semiconductor module 1 has a shape in line symmetry with respect to the predetermined axis of symmetry C. In the case where only a portion of the first temperature detection terminal T1 has a shape in line symmetry with respect to the predetermined axis of symmetry C, it is preferred that the portion includes a part connected with the first temperature detection wiring pattern 93 of the first temperature detection terminal T1. It is more preferred that such a portion includes an inner lead portion.

Further, a configuration constituted of the first to fourth semiconductor elements Q1 to Q4, the first to fourth wiring patterns 10 to 40, the first power source terminal 51, the second power source terminals 52, 53, the first intermediate point terminal 61 and the second intermediate point terminal 62 that are constitutional elements of the semiconductor module 1 are in line symmetry with reference to the predetermined axis of symmetry C. In the semiconductor module 1, the configuration that is constituted of the fifth wiring pattern 50, the board 70, the first to fourth control wiring patterns 111 to 114, the first to fourth detection wiring patterns 121 to 124, the first to fourth control terminals T11 to T14, the first to fourth detection terminals T21 to T24 and the sealing material M also is in line symmetry with respect to the predetermined axis of symmetry C.

### 2. Full bridge circuit 100 and current path in semiconductor module 1

At this stage, the full bridge circuit 100 and the current path in the semiconductor module 1 are described. As illustrated in Fig. 3 and Fig. 4, in the semiconductor module 1, the full bridge circuit 100 is constituted where the first switching path A and the second switching path B are exclusively formed by a switching operation. In Fig. 3 and Fig. 4, the first switching path A is indicated by a solid-line arrow, and the second switching path B is indicated by a broken-line arrow.

In the full bridge circuit 100 of the semiconductor module 1, the first semiconductor element Q1 and the third semiconductor element Q3 are disposed at a high side, and the second semiconductor element Q2 and the fourth semiconductor element Q4 are disposed at a low side. In such a full bridge circuit, an operation that both the first semiconductor element Q1 and the fourth semiconductor element Q4 are turned on, and an operation where both the third semiconductor element Q3 and the second semiconductor element Q2 are turned on are alternately repeated.

When both the first semiconductor element Q1 and the fourth semiconductor element Q4 are turned on, both the third semiconductor element Q3 and the second semiconductor element Q2 are turned off, while when both the third semiconductor element Q3 and the second semiconductor element Q2 are turned on, both the first semiconductor element Q1 and the fourth semiconductor element Q4 are turned off. The description relating to the state that the semiconductor element is turned off is omitted in the description hereinafter.

The first switching path A is a current path formed when both the first semiconductor element Q1 and the fourth semiconductor element Q4 are turned on as indicated by a solid line in Fig. 3 and Fig. 4. The first switching path A is a current path that includes: a first current path P1 that extends from the first power source terminal 51 to the first intermediate point terminal 61; and a second current path P2 that extends from the second intermediate point terminal 62 to the second power source terminals 52, 53. The first current path P1 is a current path where a current passes through the first power source terminal 51, the first wiring pattern 10, the first semiconductor element Q1, the second wiring pattern 20 and the first intermediate point terminal 61. The second current path P2 is a current path where a current passes through the second intermediate point terminal 62, the fourth wiring pattern 40, the fourth semiconductor element Q4, the fifth wiring pattern 50 and the second power source terminals 52, 53. In Fig. 4, it is illustrated that the second current path P2 where a current passes through the second power source terminal 53, and does not pass through the second power source terminal 52. However, such illustration is provided for preventing the complication of the drawing. In an actual configuration, in the second current path P2, a current passes through both the second power source terminals 52, 53.

Further, as indicated by a broken-line arrow in Fig. 3 and Fig. 4, the second switching path B is a current path formed when both the third semiconductor element Q3 and the second semiconductor element Q2 are turned on. The second switching path B is a current path that includes: a third current path P3 that extends from the first power source terminal 51 to the second intermediate point terminal 62; and a fourth current path P4 that extends from the first intermediate point terminal 61 to the second power source terminals 52, 53. The third current path P3 is a current path that passes through the first power source terminal 51, the third wiring pattern 30, the third semiconductor element Q3, the fourth wiring pattern 40 and the second intermediate point terminal 62. The fourth current path P4 is a current path that passes the first intermediate point terminal 61, the second wiring pattern 20, the second semiconductor element Q2, the fifth wiring pattern 50 and the second power source terminals 52, 53. In Fig. 4, it is illustrated that, in the fourth current path P4, a current passes through the second power source terminal 52, and does not pass through the second power source terminal 53. However, this illustration is provided for preventing the complication of the drawing. In an actual configuration, in the fourth current path P4, a current passes through both the second power source terminals 52, 53.

Accordingly, in the semiconductor module 1, "the wiring pattern that constitutes the common portion between the first current path P1 and the fourth current path P4" where parasitic capacitance between the pattern and the first temperature detection wiring pattern 93 is taken into consideration is the second wiring pattern 20 (see Fig. 4). Further, in the semiconductor module 1, "a wiring pattern that constitutes a common portion between the second current path P2 and the third current path P3" where a parasitic capacitance between the wiring pattern and the first temperature detection wiring pattern 93 is taken into consideration is the fourth wiring pattern 40.

### 3. Advantageous effects of semiconductor module 1 according to the embodiment

According to the semiconductor module 1 of the embodiment 1, the temperature detection element 90 is disposed in a region in the vicinity of the semiconductor elements (the second semiconductor element Q2 and the fourth semiconductor element Q4) that are heat generation source surrounded by the first switching path A and the second switching path B of the full bridge circuit 100. With such a configuration, the semiconductor module 1 according to the embodiment 1 becomes a semiconductor module capable of accurately perform temperature detection compared to a prior art.

Further, the semiconductor module 1 according to the embodiment 1 is configured to reduce noises caused by "a parasitic capacitance between the wiring pattern (the second wiring pattern 20) that constitutes the common portion of the first current path P1 and the fourth current path P4 and the first temperature detection wiring pattern 93", and "a parasitic capacitance between the wiring pattern (the fourth wiring pattern 40) that constitutes the common portion between the second current path P2 and the third current path P3 and the first temperature detection wiring pattern 93". With such a configuration, according to the semiconductor module 1 of the embodiment 1, the parasitic capacitance between the first temperature detection wiring pattern 93 and the first current path P1 on the first switching path A and the parasitic capacitance between the first temperature detection wiring pattern 93 and the second current path P2 on the first switching path A are balanced and hence, noises that are generated at the time of switching can be reduced. Further, according to the semiconductor module 1 of the embodiment 1, the parasitic capacitance between the first temperature detection wiring pattern 93 and the third current path P3 on the second switching path B, and the parasite capacitance between the first temperature detection wiring pattern 93 and the fourth current path P4 on the second switching path B are balanced and hence, noises that are generated at the time of switching can be reduced. As a result, the semiconductor module 1 according to the embodiment 1 becomes a semiconductor module that can make an output voltage of the temperature detection element 90 stable thus capable of performing the temperature detection in a stable manner.

Further, in the semiconductor module 1 according to the embodiment 1, the first temperature detection wiring pattern 93, when the semiconductor module 1 is viewed in a plan view, is disposed between the second wiring pattern 20 and the fourth wiring pattern 40. Accordingly, in the semiconductor module 1 according to the embodiment 1, it is possible to easily take a balance between the parasitic capacitance between the first temperature detection wiring pattern 93 and the first current path P1 on the first switching path A, and the parasitic capacitance between the first temperature detection wiring pattern 93 and the second current path P2 on the first switching path A. Further, in the semiconductor module 1 according to the embodiment 1, it is also possible to easily take a balance between the parasitic capacitance between the first temperature detection wiring pattern 93 and the third current path P3 on the second switching path B and the parasitic capacitance between the first temperature detection wiring pattern 93 and the fourth current path P4 on the second switching path B. With such a configuration, according to the semiconductor module 1 of the embodiment 1, noises that are generated at the time of switching can be further reduced and hence, an output voltage of the temperature detection element 90 can be made further stable whereby the temperature detection can be performed in a more stable manner.

In the semiconductor module 1 according to the embodiment 1, a distance between the first temperature detection wiring pattern 93 and the second wiring pattern 20 is equal to a distance between the first temperature detection wiring pattern 93 and the fourth wiring pattern 40. With such a configuration, according to the semiconductor module 1 of the embodiment 1, it is possible to more easily take a balance between the parasitic capacitance between the first temperature detection wiring pattern 93 and the first current path P1 on the switching path A and a parasitic capacitance between the first temperature detection wiring pattern 93 and the second current path P2 on the first switching path A. Further, according to the semiconductor module 1 of the embodiment 1, it is possible to take a balance more easily between a parasitic capacitance between the first temperature detection wiring pattern 93 and the third current path P3 on the second switching path B and the parasitic capacitance between the first temperature detection wiring pattern 93 and the fourth current path P4 on the second switching path B.

Further, in the semiconductor module 1 according to the embodiment 1, the second power source terminals 52, 53 are terminals to be connected with the ground. The plurality of wiring patterns include the fifth wiring pattern 50 to which the second power source terminals 52, 53 are connected. The fifth wiring pattern 50 has an extension portion E that extends in the direction that the first temperature detection wiring pattern 93 is arranged. With such a configuration, according to the semiconductor module 1 of the embodiment 1, by making the fifth wiring pattern 50 connected with the ground approach the first temperature detection wiring pattern 93, it is possible to reduce a parasitic capacitance generated around the first temperature detection wiring pattern 93.

Further, in the semiconductor module 1 according to the invention, embodiment 1, when the semiconductor module 1 is viewed in a plan view, the first temperature detection wiring pattern 93 and the first temperature detection terminal T1 are arranged at the position that overlaps with the predetermined axis of symmetry C. Further, in the semiconductor module 1 according to the embodiment 1, at least a portion of the first temperature detection terminal T1 and the first temperature detection wiring pattern 93 have a shape in a line symmetry with respect to the predetermined axis of symmetry C. Further, in the semiconductor module 1 according to the embodiment 1, the first to fourth semiconductor elements Q1 to Q4, the first to fourth wiring patterns 10 to 40, the first power source terminal 51, the second power source terminals 52, 53, the first intermediate point terminal 61 and the second intermediate point terminal 62 that are constitutional elements of the semiconductor module 1 are in line symmetry with respect to the predetermined axis of symmetry C. With such a configuration, according to the semiconductor module 1 of the embodiment 1, by making the shapes of the first switching path A and the second switching path B approach a line symmetry, it is possible to take more easily a balance between the parasitic capacitances generated around the first temperature detection wiring pattern 93.

### [Embodiment 2]

A semiconductor module 2 according to an embodiment 2 basically has substantially the same configuration as the semiconductor module 1 according to the embodiment 1. However, the semiconductor module 2 according to the embodiment 2 differs from the semiconductor module 1 according to the embodiment 1 with respect to a point that the semiconductor module 2 according to the embodiment 2 further includes a capacitive coupling reducing wiring pattern. Hereinafter, the semiconductor module 2 is described by focusing on the point that makes the semiconductor module 2 differ from the semiconductor module 1.

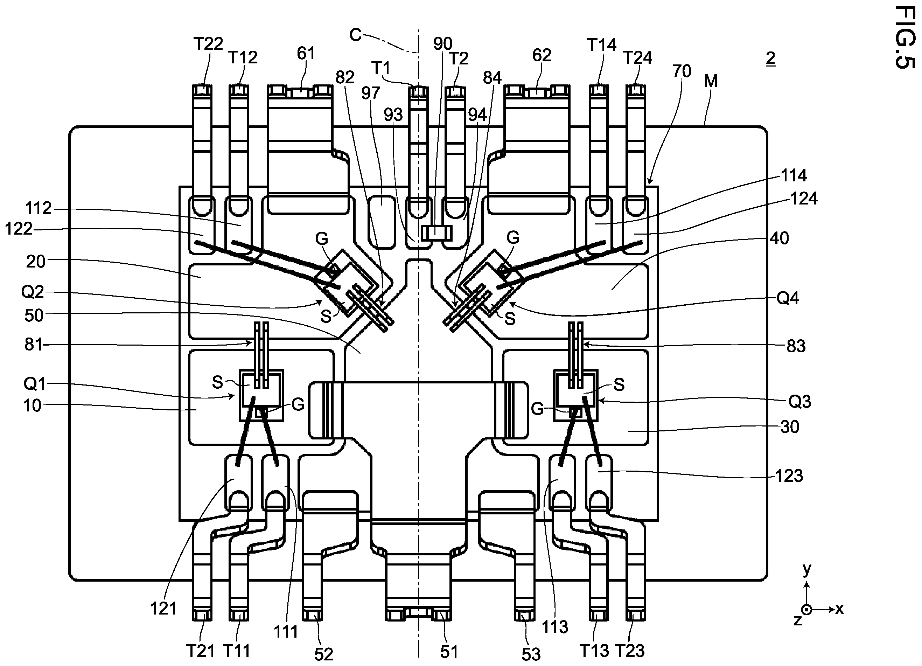

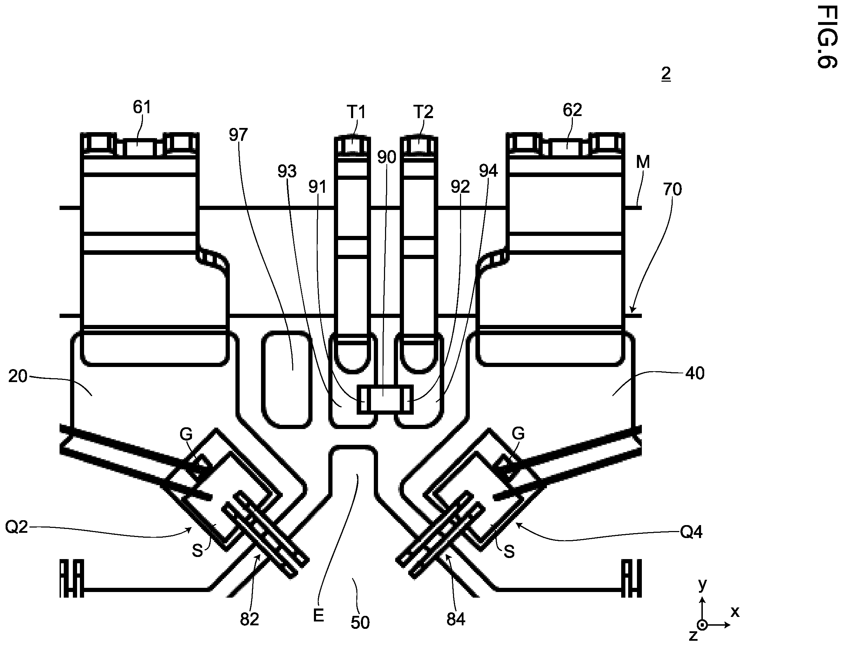

As illustrated in Fig. 5 and Fig. 6, the semiconductor module 2 includes a capacitive coupling reducing wiring pattern 97. The capacitive coupling reducing wiring pattern 97 is arranged on a side where a second temperature detection wiring pattern 94 is not arranged out of between a first temperature detection wiring pattern 93 and a second wiring pattern 20 and between the first temperature detection wiring pattern 93 and a fourth wiring pattern 40. In the semiconductor module 2, the second temperature detection wiring pattern 94 is disposed between the first temperature detection wiring pattern 93 and the fourth wiring pattern 40. Accordingly, the capacitive coupling reducing wiring pattern 97 in the semiconductor module 2 is disposed between the first temperature detection wiring pattern 93 and the second wiring pattern 20.

Although not illustrated in the drawing, in the semiconductor module 2, a full bridge circuit 100 substantially equal to the full bridge circuit 100 in the semiconductor module 1 is formed. In use, a first switching path A and a second switching path B substantially equal to the corresponding paths in the semiconductor module 1 are formed. With respect to the full bridge circuit 100, the first switching path A and the second switching path B, the same goes for semiconductor modules 3, 4 described later.

The semiconductor module 2 according to the embodiment 2 differs from the semiconductor module 1 according to the embodiment 1 with respect to the point that the semiconductor module 2 further includes the capacitive coupling reducing wiring pattern. However, a temperature detection element 90 is disposed in the vicinity of semiconductor elements (a second semiconductor element Q2 and a fourth semiconductor element Q4) that are heat generating sources and are surrounded by the first switching path A and the second switching path B in the full bridge circuit 100. Accordingly, the semiconductor module 2 according to the embodiment 2, in the same manner as the semiconductor module 1 according to the embodiment 1, becomes a semiconductor module that can more accurately perform the temperature detection than a conventional semiconductor module.

The semiconductor module 2 according to the embodiment 2 includes, out of between the first temperature detection wiring pattern 93 and the second wiring pattern 20 and between the first temperature detection wiring pattern 93 and the fourth wiring pattern 40, the capacitive coupling reducing wiring pattern 97 that is disposed on a side where the second temperature detection wiring pattern 94 is not disposed. According to the semiconductor module 2 according to the embodiment 2, as illustrated in examples described later, due to the provision of the capacitive coupling reducing wiring pattern 97, it is possible to reduce a parasitic capacitance generated around the first temperature detection wiring pattern 93.

The semiconductor module 2 according to the embodiment 2 has all configurations that the semiconductor module 1 according to the embodiment 1 has and hence, the semiconductor module 2 according to the embodiment 2 also has advantageous effects substantially equal to the advantageous effects that the semiconductor module 1 according to the embodiment 1 has.

### [Embodiment 3]

A semiconductor module 3 according to an embodiment 3 basically has substantially the same configuration as the semiconductor module 2 according to the embodiment 2. However, the semiconductor module 3 according to the embodiment 3 differs from the semiconductor module 2 according to the embodiment 2 with respect to a point that a capacitive coupling reducing wiring pattern is connected with a fifth wiring pattern. Hereinafter, the semiconductor module 3 is explained by focusing on the point that makes the semiconductor module 3 differ from the semiconductor module 2.

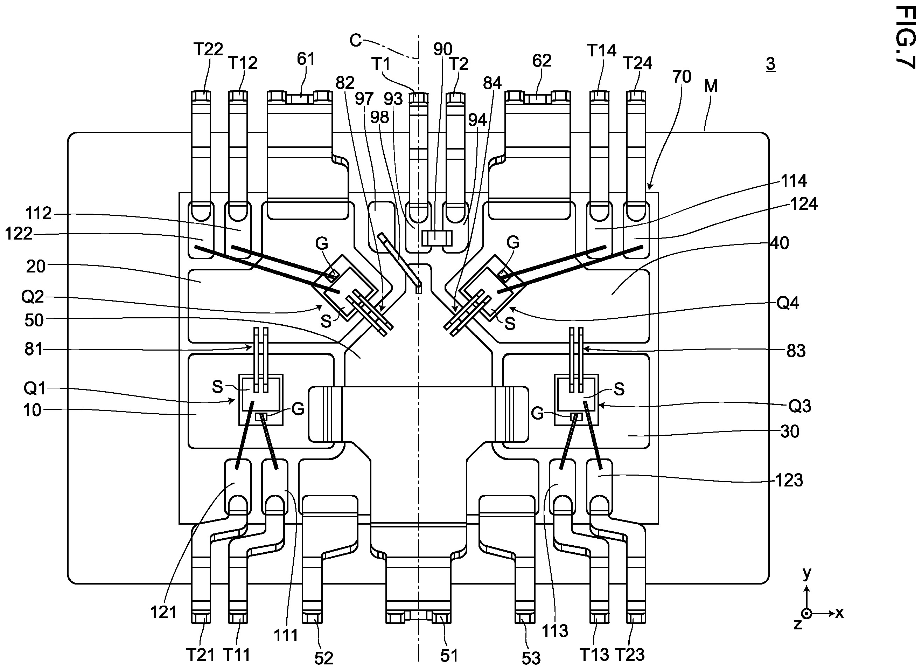

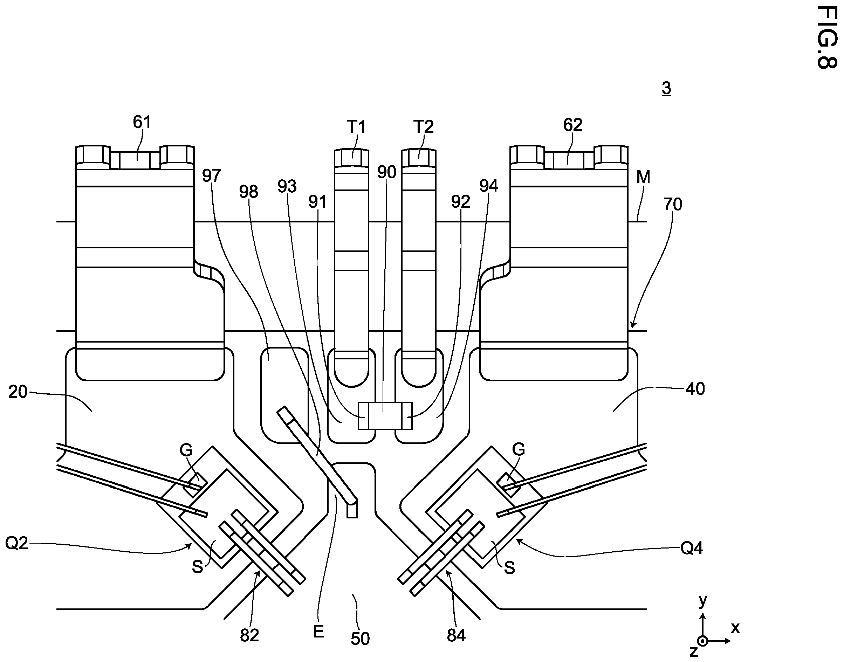

As illustrated in Fig. 7 and Fig. 8, the semiconductor module 3 includes a capacitive coupling reducing connecting member 98. The capacitive coupling reducing connecting member 98 is a conductive member (for example, aluminum wire) that connects a capacitive coupling reducing wiring pattern 97 and a fifth wiring pattern 50 with each other. With such a configuration, in the semiconductor module 3, the capacitive coupling reducing wiring pattern 97 is connected with the fifth wiring pattern 50.

Second power source terminals 52, 53 are terminals to be connected with a ground. The second power source terminals 52, 53 are connected with the fifth wiring pattern 50 and hence, it is safe to say that the capacitive coupling reducing wiring pattern 97 in the semiconductor module 3 is connected with the ground.

The semiconductor module 3 according to the embodiment 3 differs from the semiconductor module 2 according to the embodiment 2 with respect to the point that the capacitive coupling reducing wiring pattern is connected with the fifth wiring pattern. However, a temperature detection element 90 is disposed in the vicinity of semiconductor elements (a second semiconductor element Q2 and a fourth semiconductor element Q4) that are heat generating sources and are surrounded by a first switching path A and a second switching path B in a full bridge circuit 100. Accordingly, the semiconductor module 3 according to the embodiment 3, in the same manner as the semiconductor module 2 according to the embodiment 2, becomes a semiconductor module that can more accurately perform the temperature detection than a conventional semiconductor module.

Further, in the semiconductor module 3 according to the embodiment 3, the capacitive coupling reducing wiring pattern 97 is connected with the ground and hence, as illustrated in examples described later, a parasitic capacitance that is generated around the first temperature detection wiring pattern 93 can be further reduced.

In the semiconductor module 3 according to the embodiment 3, the second power source terminals 52, 53 are terminals to be connected with the ground, a plurality of wiring patterns include the fifth wiring pattern 50 with which the second power source terminals 52, 53 are connected, and the capacitive coupling reducing wiring pattern 97 is connected with the fifth wiring pattern 50. With such a configuration, according to the semiconductor module 3 of the embodiment 3, the capacitive coupling reducing wiring pattern 97 can be connected with the ground via the fifth wiring pattern 50.

The semiconductor module 3 according to the embodiment 3 has all configurations that the semiconductor module 2 according to the embodiment 2 has and hence, the semiconductor module 3 according to the embodiment 3 also has advantageous effects substantially equal to the advantageous effects that the semiconductor module 2 according to the embodiment 2 has.

### [Embodiment 4]

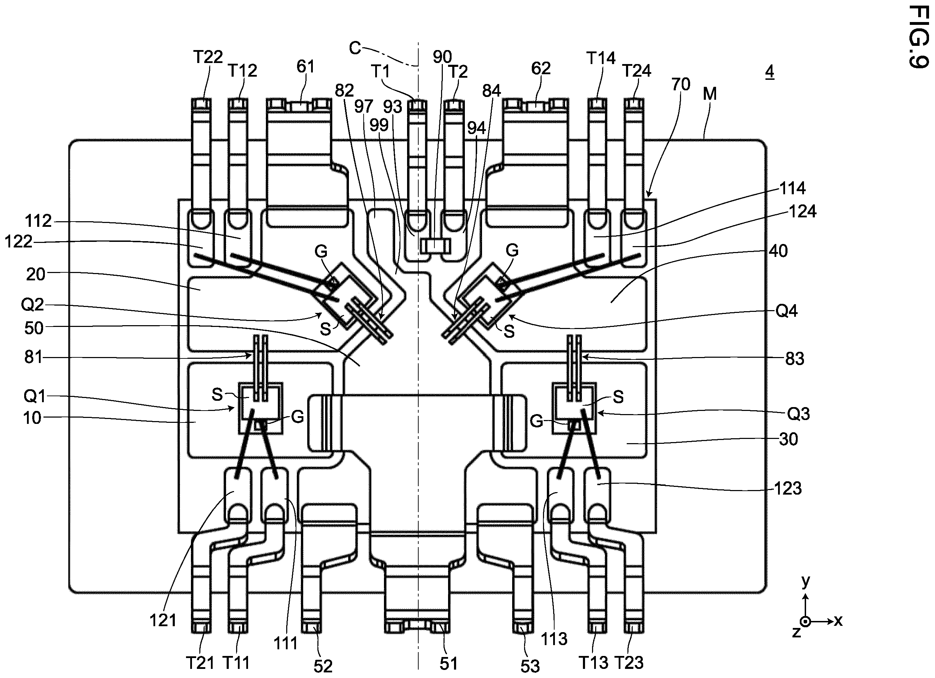

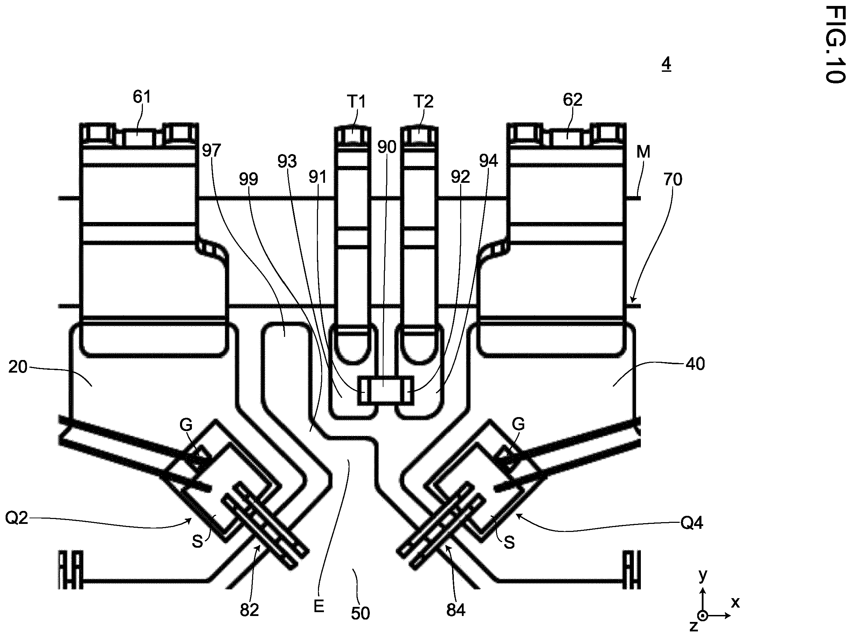

A semiconductor module 4 according to an embodiment 4 basically has substantially the same configuration as the semiconductor module 3 according to the embodiment 3. However, as illustrated in Fig. 9 and Fig. 10, the semiconductor module 4 according to the embodiment 4 includes a connecting wiring pattern 99 instead of the capacitive coupling reducing wiring member 98. The connecting wiring pattern 99 is a wiring pattern that connects a capacitive coupling reducing wiring pattern 97 and a wiring pattern 50 with each other.

The semiconductor module 4 according to the embodiment 4 has substantially the same advantageous effects that the semiconductor module 3 according to the embodiment 3 has.

### [Examples]

Hereinafter, the description is made with respect to a result obtained by a simulation performed by inventors of the present invention relating to advantageous effects of the present invention.

Such simulation was carried out with respect to the semiconductor modules 1 to 4 according to the embodiment 1 to 4 and a semiconductor module 1A according to a comparison example.

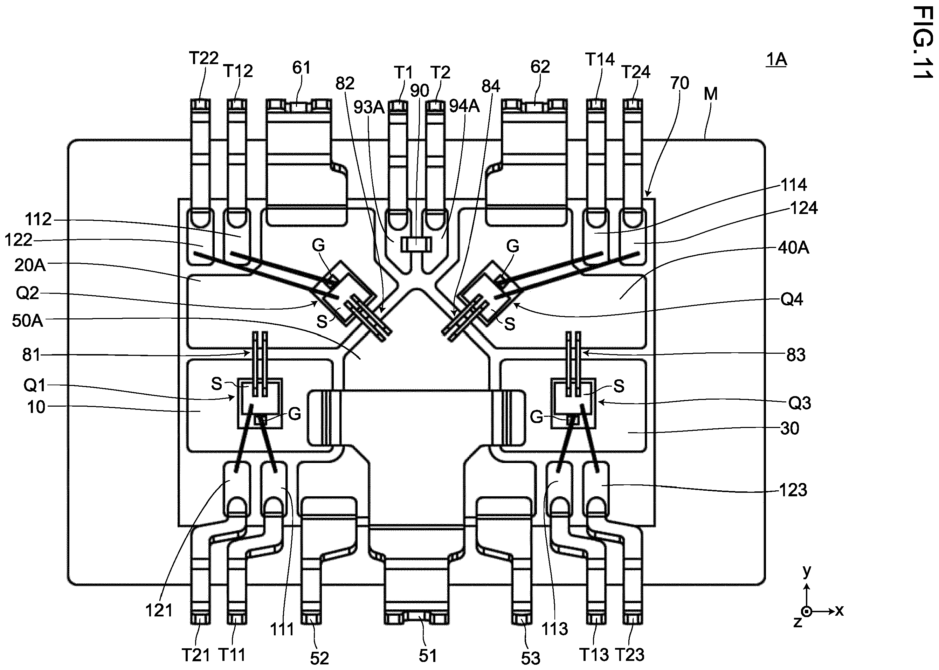

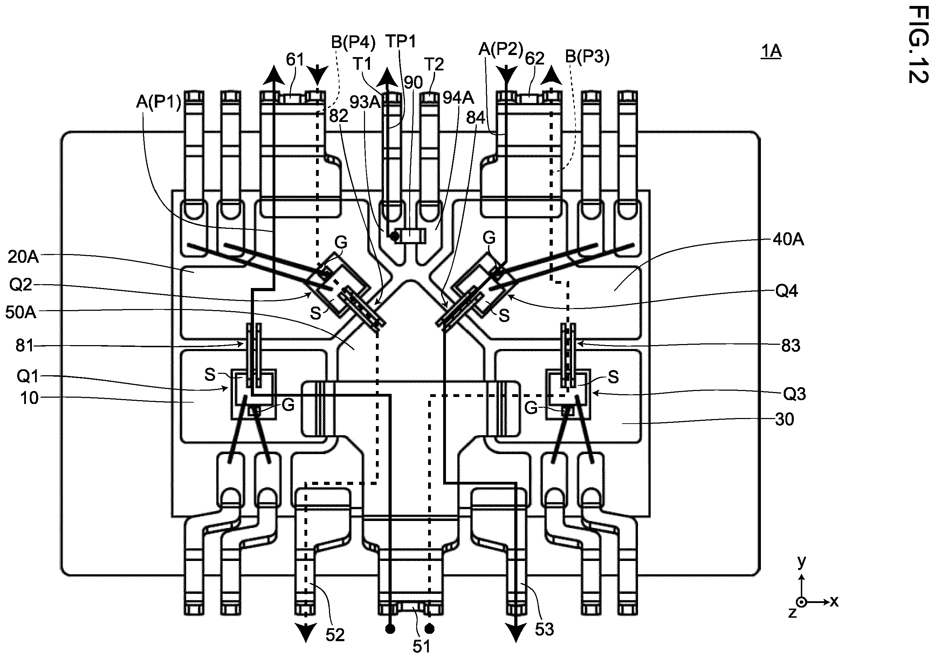

As illustrated in Fig. 11 and Fig. 12, the semiconductor module 1A basically has substantially the same configuration as the semiconductor module 1 according to the embodiment 1. However, a balance between a parasitic capacitance between a second wiring pattern and a first temperature detection wiring pattern, and a parasitic capacitance between a fourth wiring pattern and a first temperature detection wiring pattern is not taken into consideration. A temperature detection element 90, a first temperature detection terminal T1 and a second temperature detection terminal T2 in the semiconductor module 1A are equal to the corresponding constitutional elements in the semiconductor module 1. However, these constitutional elements differ in positions where these constitutional elements are disposed. Further, attributed to the above-mentioned difference, the semiconductor module 1A includes a second wiring pattern 20A, a fourth wiring pattern 40A, a fifth wiring pattern 50A, a first temperature detection pattern 93A and a second temperature detection pattern 94A having shapes that differ from the corresponding constitutional elements having the same names in the semiconductor module 1.

First, with respect to the semiconductor modules 1 to 4 according to the embodiments 1 to 4 and the semiconductor module 1A according to the comparison example, the difference between a parasitic capacitance between the first temperature detection wiring patterns 93, 93A and the second wiring patterns 20, 20A and a parasitic capacitance between the first temperature detection wiring patterns 93, 93A and the fourth wiring patterns 40, 40A (hereinafter, referred to as "difference in parasitic capacitance") was measured.

As a result, a difference in parasitic capacitance in the semiconductor module 1A was 307fF. On the other hand, the difference in parasitic capacitance in the semiconductor module 1 was 109fF, the difference in parasitic capacitance in the semiconductor module 2 was 98fF, the difference in parasitic capacitance in the semiconductor module 3 was 95fF, and the difference in parasitic capacitance in the semiconductor module 4 was 97fF.

From the above-mentioned result, it was confirmed that a balance of parasitic capacitance around the first temperature detection wiring pattern 93 in the semiconductor modules 1 to 4 according to the embodiments 1 to 4 is more favorable than the corresponding balance in the semiconductor module 1A according to the comparison example. Further, from the above-mentioned result, it was confirmed that the balance of the parasitic capacitance is further improved by the capacitive coupling reducing wiring pattern 97, and the balance in parasitic capacitance is further improved due to connection between the capacitive coupling reducing wiring pattern 97 and a ground.

Next, with respect to the semiconductor module 3 according to the embodiment 3 and the semiconductor module 1A according to the comparison example, assuming frequency of an ON/OFF operation of the full bridge circuit 100 as 20kHz, noises (a fluctuation in voltage) generated in a first temperature detection path TP1 (a current path that extends from the first temperature detection electrode 91 to the first temperature detection terminal T1, see Fig. 1 and Fig. 12) at the time of performing switching was measured.

As a result, as illustrated in Fig. 13, in the semiconductor module 3 according to the embodiment 3, noises generated in the first temperature detection path TP1 are largely reduced compared to the semiconductor module 1A according to the comparison example. Accordingly, in the semiconductor module 3 according to the embodiment 3, an output voltage of the temperature detection element 90 became stable.

The present invention has been described based on the above-mentioned respective embodiments, the present invention is not limited to the above-mentioned respective embodiments. Various modes can be carried out without departing from the gist of the present invention. For example, the following modifications are also conceivable.
(1) The positions, the sizes, the shapes and the like of the respective constitutional elements that are described in the above-mentioned respective embodiments and are illustrated in the respective drawings are provided for an exemplifying purpose, and can be changed within a scope where the advantageous effects of the present invention are not impaired.
(2) In the above-mentioned embodiments 3,4, the capacitive coupling reducing wiring pattern 97 is connected with the ground via the fifth wiring pattern 50. However, the present invention is not limited to such a configuration. The capacitive coupling reducing wiring pattern according to the present invention may be connected with the ground not via the fifth wiring pattern. Such a configuration can be realized by connecting a dedicated terminal to the capacitive coupling reducing wiring pattern, for example.
(3) In the above-mentioned embodiments 2 to 4, the second temperature detection wiring pattern 94 is disposed between the first temperature detection wiring pattern 93 and the fourth wiring pattern 40, and the capacitive coupling reducing wiring pattern 97 is disposed between the first temperature detection wiring pattern 93 and the second wiring pattern 20. However, the present invention is not limited to such a configuration. The arrangement of the second temperature detection wiring pattern and the capacitive coupling reducing wiring pattern may be reversed. In this case, it is necessary to also adjust the arrangement of the temperature detection element and the second temperature detection terminal.
(4) In the above-mentioned embodiments 3, 4, the capacitive coupling reducing wiring pattern 97 is a pattern to be connected with the ground. However, the present invention is not limited to such a configuration. The capacitive coupling reducing wiring pattern may be a pattern to be connected with a connection destination other than the ground. In this case, it is preferred that the connection destination other than the ground is a connection destination where a voltage is stable. As the connection destination where a voltage is stable, for example, various power supplies (a main power source, a control system power source and the like) can be exemplified. Also, by adopting such configurations, a parasitic capacitance that occurs around the first temperature detection wiring pattern can be further reduced.

### [Reference Signs List]

1,2,3,4: semiconductor module
10: first wiring pattern
20: second wiring pattern
30: third wiring pattern
40: fourth wiring pattern
50: fifth wiring pattern
51: first power source terminal
52, 53: second power source terminal
61: first intermediate point terminal
62: second intermediate point terminal
90: temperature detection element
91: first temperature detection electrode
92: second temperature detection electrode
93: first temperature detection wiring pattern
94: second temperature detection wiring pattern
97: capacitive coupling reducing wiring pattern
100: full bridge circuit
A: first switching path
B: second switching path
P1: first current path
P2: second current path
P3: third current path
P4: fourth current path
Q1: first semiconductor element
Q2: second semiconductor element
Q3: third semiconductor element
Q4: fourth semiconductor element
T1: first temperature detection terminal
T2: second temperature detection terminal

## Claims

1. A semiconductor module (900) comprising: first to fourth semiconductor elements (Q1-Q4); a plurality of wiring patterns; a first power source terminal (51); a second power source terminal (52, 53); a first intermediate point terminal (61) and a second intermediate point terminal (62), wherein a full bridge circuit (100) is formed in the semiconductor module (900) where the first semiconductor element and the third semiconductor element are disposed at a high side and the second semiconductor element and the fourth semiconductor element are disposed at a low side therein, wherein
the semiconductor module (900) further comprises:
a temperature detection element (90) having a first temperature detection electrode (91) and a second temperature detection electrode (92);
a first temperature detection wiring pattern (93) that is connected with the first temperature detection electrode (91);
a first temperature detection terminal that is a terminal to be connected with the temperature detection circuit and is connected with the first temperature detection wiring pattern (93);
a second temperature detection wiring pattern (94) that is connected with the second temperature detection electrode (92); and
a second temperature detection terminal that is a terminal to be connected with a ground or a control system power source, and is connected with the second temperature detection wiring pattern (94), wherein
a current path that is formed when both the first semiconductor element and the fourth semiconductor element are turned on and includes a first current path that extends from the first power source terminal (51) to the first intermediate point terminal (61) and a second current path that extends from the second intermediate point terminal (62) to the second power source terminal (52, 53) is set as a first switching path, and
a current path that is formed when both the third semiconductor element and the second semiconductor element are turned on and includes a third current path that extends from the first power source terminal (51) to the second intermediate point terminal (62) and a fourth current path that extends from the first intermediate point terminal (61) to the second power source terminal (52, 53) is set as a second switching path, and
the temperature detection element (90) is disposed in a region surrounded by the first switching path and the second switching path, whereby
the semiconductor module (900) is configured to reduce noises caused by a parasitic capacitance between a wiring pattern that constitutes a common portion of the first current path and the fourth current path and the first temperature detection wiring pattern (93), and a parasitic capacitance between a wiring pattern that constitutes a common portion of the second current path and the third current path and the first temperature detection wiring pattern; wherein
the plurality of wiring patterns include: a first wiring pattern (10) on which the first semiconductor element is mounted and with which the first power source terminal (51) is connected; a second wiring pattern (20,) on which the second semiconductor element is mounted and with which the first intermediate point terminal (61) is connected; a third wiring pattern (30) on which the third semiconductor element is mounted and with which the first power source terminal (51) is connected; and a fourth wiring pattern (40) on which the fourth semiconductor element is mounted and with which the second intermediate point terminal (62) is connected, and
the first temperature detection wiring pattern (93), when the semiconductor module (900) is viewed in a plan view, is disposed between the second wiring pattern (20,) and the fourth wiring pattern; and wherein
when the semiconductor module (900) is viewed in a plan view, the first temperature detection wiring pattern (93) and the first temperature detection terminal are disposed at a position where the first temperature detection wiring pattern (93) and the first temperature detection terminal overlap with a predetermined axis of symmetry,
at least a portion of the first temperature detection terminal and the first temperature detection wiring pattern (93) have a shape where the portion and the first temperature detection wiring pattern (93) are in line symmetry with reference to the predetermined axis of symmetry, and
the first to fourth semiconductor elements (Q1-Q4), the first to fourth wiring patterns (40), the first power source terminal (51), the second power source terminals (52, 53), the first intermediate point terminal (61) and the second intermediate point terminal (62) that are constitutional elements of the semiconductor module (900) are in line symmetry with respect to the predetermined axis of symmetry.

2. The semiconductor module (900) according to claim 1, wherein a distance between the first temperature detection wiring pattern (93) and the second wiring pattern (20,) is equal to a distance between the first temperature detection wiring pattern (93) and the fourth wiring pattern (40).

3. The semiconductor module (900) according to claim 1 or 2, wherein the second power source terminal (52, 53) is a terminal to be connected with the ground,
the plurality of wiring patterns further include a fifth wiring pattern (50) with which the second power source terminal (52, 53) is connected, and
the fifth wiring pattern (50) includes an extension portion that extends in a direction that the first temperature detection wiring pattern (93) is disposed.

4. The semiconductor module (900) according to any one of claims 1 to 3, wherein the second temperature detection wiring pattern (94) is disposed between the first temperature detection wiring pattern (93) and the second wiring pattern (20,) or between the first temperature detection wiring pattern (93) and the fourth wiring pattern (40), and
the semiconductor module (900) further includes a capacitive coupling reducing wiring pattern (97) that is disposed on the side where the second temperature detection wiring pattern (94) is not disposed out of between the first temperature detection wiring pattern (93) and the second wiring pattern (20,) and between the first temperature detection wiring pattern (93) and the fourth wiring pattern (40).

5. The semiconductor module (900) according to claim 4, wherein the capacitive coupling reducing wiring pattern (97) is a pattern that is connected with the ground.

6. The semiconductor module (900) according to claim 5, wherein the second power source terminal (52, 53) is a terminal to be connected with the ground,
the plurality of wiring patterns further include a fifth wiring pattern (50) with which the second power source terminal (52, 53) is connected, and
the capacitive coupling reducing wiring pattern (97) is connected with the fifth wiring pattern (50).

## Patentansprüche

1. Halbleitermodul (900), aufweisend: vier Halbleiterelemente (Q1 - Q4); eine Mehrzahl von Verdrahtungsstrukturen; einen ersten Stromversorgungsanschluss (51); einen zweiten Stromversorgungsanschluss (52, 53); einen ersten Verteileranschluss (61) und einen zweiten Verteileranschluss (62), wobei im Halbleitermodul (900) eine Vollbrückenschaltung (100) gebildet ist, in welcher das erste Halbleiterelement und das dritte Halbleiterelement an einer Spannungsseite (High Side) angeordnet sind, und das zweite Halbleiterelement und das vierte Halbleiterelement an einer Steuerseite (Low Side) angeordnet sind, wobei
das Halbleitermodul (900) ferner aufweist:
ein Temperaturerfassungselement (90), welches eine erste Temperaturerfassungselektrode (91) und eine zweite Temperaturerfassungselektrode (92) aufweist;
eine erste Temperaturerfassungsverdrahtungsstruktur (93), welche mit der ersten Temperaturerfassungselektrode (91) verbunden ist;
einen ersten Temperaturerfassungsanschluss, bei welchem es sich um einen mit der Temperaturerfassungsschaltung zu verbindenden Anschluss handelt, welcher mit der ersten Temperaturerfassungsverdrahtungsstruktur (93) verbunden ist;
eine zweite Temperaturerfassungsverdrahtungsstruktur (94), welche mit der zweiten Temperaturerfassungselektrode (92) verbunden ist; und
einen zweiten Temperaturerfassungsanschluss, bei welchem es sich um einen mit einer Masse oder einer Steuersystemstromquelle zu verbindenden Anschluss handelt, welcher mit der zweiten Temperaturerfassungsverdrahtungsstruktur (94) verbunden ist, wobei
ein Strompfad, welcher gebildet ist, wenn sowohl das erste Halbleiterelement als auch das vierte Halbleiterelement eingeschaltet sind, und welcher einen ersten Strompfad, welcher sich vom ersten Stromversorgungsanschluss (51) zum ersten Verteileranschluss (61) erstreckt, und einen zweiten Strompfad, welcher sich vom zweiten Verteileranschluss (62) zum zweiten Stromversorgungsanschluss (52, 53) erstreckt, aufweist, als ein erster Schaltweg festgelegt ist, und
ein Strompfad, welcher gebildet ist, wenn sowohl das dritte Halbleiterelement als auch das zweite Halbleiterelement eingeschaltet sind, und welcher einen dritten Strompfad, welcher sich vom ersten Stromversorgungsanschluss (51) zum zweiten Verteileranschluss (62) erstreckt, und einen vierten Strompfad, welcher sich vom ersten Verteileranschluss (61) zum zweiten Stromversorgungsanschluss (52, 53) erstreckt, aufweist, als ein zweiter Schaltweg festgelegt ist, und
das Temperaturerfassungselement (90) in einem Bereich, welcher vom ersten Schaltweg und vom zweiten Schaltweg umgeben ist, angeordnet ist, wobei
das Halbleitermodul (900) dafür eingerichtet ist, ein Rauschen, welches durch eine parasitäre Kapazität zwischen einer Verdrahtungsstruktur, welche einen gemeinsamen Abschnitt des ersten Strompfads und des vierten Strompfads darstellt, und der ersten Temperaturerfassungsverdrahtungsstruktur (93), und eine parasitäre Kapazität zwischen einer Verdrahtungsstruktur, welche einen gemeinsamen Abschnitt des zweiten Strompfads und des dritten Strompfads darstellt, und der ersten Temperaturerfassungsverdrahtungsstruktur verursacht wird, zu reduzieren; wobei
die Mehrzahl an Verdrahtungsstrukturen aufweist: eine erste Verdrahtungsstruktur (10), an welcher das erste Halbleiterelement angebracht ist und mit welcher der erste Stromversorgungsanschluss (51) verbunden ist; eine zweite Verdrahtungsstruktur (20), an welcher das zweite Halbleiterelement angebracht ist und mit welcher der erste Verteileranschluss (61) verbunden ist; eine dritte Verdrahtungsstruktur (30), an welcher das dritte Halbleiterelement angebracht ist und mit welcher der erste Stromversorgungsanschluss (51) verbunden ist; und eine vierte Verdrahtungsstruktur (40), an welcher das vierte Halbleiterelement angebracht ist und mit welcher der zweite Verteileranschluss (62) verbunden ist, und
die erste Temperaturerfassungsverdrahtungsstruktur (93), wenn man das Halbleitermodul (900) in einer Draufsicht betrachtet, zwischen der zweiten Verdrahtungsstruktur (20) und der vierten Verdrahtungsstruktur angeordnet ist; und wobei
wenn man das Halbleitermodul (900) in einer Draufsicht betrachtet, die erste Temperaturerfassungsverdrahtungsstruktur (93) und der erste Temperaturerfassungsanschluss an einer Position angebracht sind, an welcher sich die erste Temperaturerfassungsverdrahtungsstruktur (93) und der erste Temperaturerfassungsanschluss mit einer vorgegebenen Symmetrieachse überlappen,
mindestens ein Abschnitt des ersten Temperaturerfassungsanschlusses und die erste Temperaturerfassungsverdrahtungsstruktur (93) eine Form aufweisen, in welcher der Abschnitt und die erste Temperaturerfassungsverdrahtungsstruktur (93) in Bezug auf die vorgegebene Symmetrieachse liniensymmetrisch angeordnet sind, und
die vier Halbleiterelemente (Q1 - Q4), die vier Verdrahtungsstrukturen (40), der erste Stromversorgungsanschluss (51), die zweiten Stromversorgungsanschlüsse (52, 53), der erste Verteileranschluss (61) und der zweite Verteileranschluss (62), welche wesentliche Bestandteile des Halbleitermoduls (900) darstellen, in Bezug auf die vorgegebene Symmetrieachse liniensymmetrisch angeordnet sind.

2. Halbleitermodul (900) nach Anspruch 1, wobei ein Abstand zwischen der ersten Temperaturerfassungsverdrahtungsstruktur (93) und der zweiten Verdrahtungsstruktur (20) gleich einem Abstand zwischen der ersten Temperaturerfassungsverdrahtungsstruktur (93) und der vierten Verdrahtungsstruktur (40) ist.

3. Halbleitermodul (900) nach Anspruch 1 oder 2, wobei der zweite Stromversorgungsanschluss (52, 53) ein mit einer Masse zu verbindender Anschluss ist,
die Mehrzahl an Verdrahtungsstrukturen ferner eine fünfte Verdrahtungsstruktur (50) aufweist, mit welcher der zweite Stromversorgungsanschluss (52, 53) verbunden ist, und
die fünfte Verdrahtungsstruktur (50) einen Erweiterungsabschnitt aufweist, welcher sich in eine Richtung in welcher die erste Temperaturerfassungsverdrahtungsstruktur (93) angeordnet ist, erstreckt.

4. Halbleitermodul (900) nach einem der Ansprüche 1 bis 3, wobei die zweite Temperaturerfassungsverdrahtungsstruktur (94) zwischen der ersten Temperaturerfassungsverdrahtungsstruktur (93) und der zweiten Verdrahtungsstruktur (20), oder zwischen der ersten Temperaturerfassungsverdrahtungsstruktur (93) und der vierten Verdrahtungsstruktur (40) angeordnet ist, und
das Halbleitermodul (900) ferner eine Verdrahtungsstruktur zum Reduzieren einer kapazitiven Kopplung (97) aufweist, welche an der Seite, an welcher die zweite Temperaturerfassungsverdrahtungsstruktur (94) nicht angeordnet ist, zwischen der ersten Temperaturerfassungsverdrahtungsstruktur (93) und der zweiten Verdrahtungsstruktur (20) und zwischen der ersten Temperaturerfassungsverdrahtungsstruktur (93) und der vierten Verdrahtungsstruktur (40) angeordnet ist.

5. Halbleitermodul (900) nach Anspruch 4, wobei die Verdrahtungsstruktur zum Reduzieren der kapazitiven Kopplung (97) eine Struktur ist, welche mit der Masse verbunden ist.

6. Halbleitermodul (900) nach Anspruch 5, wobei der zweite Stromversorgungsanschluss (52, 53) ein mit der Masse zu verbindender Anschluss ist,
die Mehrzahl an Verdrahtungsstrukturen ferner eine fünfte Verdrahtungsstruktur (50) aufweist, mit welcher der zweite Stromversorgungsanschluss (52, 53) verbunden ist, und
die Verdrahtungsstruktur zum Reduzieren der kapazitiven Kopplung (97) mit der fünften Verdrahtungsstruktur (50) verbunden ist.

## Revendications

1. Module à semi-conducteurs (900) comprenant : des premier à quatrième éléments semi-conducteurs (Q1-Q4) ; une pluralité de motifs de câblage ; une première borne de source d'alimentation (51) ; une deuxième borne de source d'alimentation (52, 53) ; une première borne de point intermédiaire (61) et une deuxième borne de point intermédiaire (62), où un circuit en pont complet (100) est formé dans le module à semi-conducteurs (900) où le premier élément semi-conducteur et le troisième élément semi-conducteur sont disposés sur un côté haut et le deuxième élément semi-conducteur et le quatrième élément semi-conducteur sont disposés sur un côté bas dans celui-ci, où
le module à semi-conducteurs (900) comprend en outre :
un élément de détection de température (90) comprenant une première électrode de détection de température (91) et une deuxième électrode de détection de température (92) ;
un premier motif de câblage de détection de température (93) qui est connecté à la première électrode de détection de température (91) ;
une première borne de détection de température qui est une borne à connecter au circuit de détection de température et qui est connectée au premier motif de câblage de détection de température (93) ;
un deuxième motif de câblage de détection de température (94) qui est connecté à la deuxième électrode de détection de température (92) ; et
une deuxième borne de détection de température qui est une borne à connecter à une masse ou à une source d'alimentation du système de commande, et qui est connectée au deuxième motif de câblage de détection de température (94), où
un chemin de courant formé lorsque le premier élément semi-conducteur et le quatrième élément semi-conducteur sont tous deux mis sous tension et comprenant un premier chemin de courant qui s'étend de la première borne de source d'alimentation (51) à la première borne de point intermédiaire (61) et un deuxième chemin de courant qui s'étend de la deuxième borne de point intermédiaire (62) à la deuxième borne de source d'alimentation (52, 53) est défini comme premier chemin de commutation, et
un chemin de courant formé lorsque le troisième élément semi-conducteur et le deuxième élément semi-conducteur sont tous deux mis sous tension et comprenant un troisième chemin de courant qui s'étend de la première borne de source d'alimentation (51) à la deuxième borne de point intermédiaire (62) et un quatrième chemin de courant qui s'étend de la première borne de point intermédiaire (61) à la deuxième borne de source d'alimentation (52, 53) est défini comme un deuxième chemin de commutation, et
l'élément de détection de température (90) est disposé dans une région entourée par le premier chemin de commutation et le deuxième chemin de commutation, moyennant quoi
le module à semi-conducteurs (900) est configuré pour réduire les bruits causés par une capacité parasite entre un motif de câblage qui constitue une partie commune du premier chemin de courant et du quatrième chemin de courant et le premier motif de câblage de détection de température (93), et une capacité parasite entre un motif de câblage qui constitue une partie commune du deuxième chemin de courant et du troisième chemin de courant et le premier motif de câblage de détection de température ; où
la pluralité de motifs de câblage comprend : un premier motif de câblage (10) sur lequel est monté le premier élément semi-conducteur et auquel est connectée la première borne de source d'alimentation (51) ; un deuxième motif de câblage (20) sur lequel est monté le deuxième élément semi-conducteur et auquel est connectée la première borne de point intermédiaire (61) ; un troisième motif de câblage (30) sur lequel est monté le troisième élément semi-conducteur et auquel est connectée la première borne de source d'alimentation (51) ; et un quatrième motif de câblage (40) sur lequel est monté le quatrième élément semi-conducteur et sur lequel est connectée la deuxième borne de point intermédiaire (62), et
le premier motif de câblage de détection de température (93), lorsque le module à semi-conducteurs (900) est visualisé en vue en plan, est disposé entre le deuxième motif de câblage (20) et le quatrième motif de câblage ; et où
lorsque le module à semi-conducteurs (900) est visualisé en vue en plan, le premier motif de câblage de détection de température (93) et la première borne de détection de température sont disposés à une position où le premier motif de câblage de détection de température (93) et la première borne de détection de température se chevauchent avec un axe de symétrie prédéterminé,
au moins une partie de la première borne de détection de température et le premier motif de câblage de détection de température (93) ont une forme dans laquelle la partie et le premier motif de câblage de détection de température (93) présentent une symétrie axiale par rapport à l'axe de symétrie prédéterminé, et
les premier à quatrième éléments semi-conducteurs (Q1-Q4), les premier à quatrième motifs de câblage (40), la première borne de source d'alimentation (51), les deuxièmes bornes de source d'alimentation (52, 53), la première borne de point intermédiaire (61) et la deuxième borne de point intermédiaire (62) qui sont des éléments constitutifs du module à semi-conducteurs (900) présentent une symétrie axiale par rapport à l'axe de symétrie prédéterminé.

2. Module à semi-conducteurs (900) selon la revendication 1, dans lequel la distance entre le premier motif de câblage de détection de température (93) et le deuxième motif de câblage (20) est égale à la distance entre le premier motif de câblage de détection de température (93) et le quatrième motif de câblage (40).

3. Module à semi-conducteurs (900) selon la revendication 1 ou la revendication 2, dans lequel la deuxième borne de source d'alimentation (52, 53) est une borne à connecter à la masse,
la pluralité de motifs de câblage comprend en outre un cinquième motif de câblage (50) auquel la deuxième borne de source d'alimentation (52, 53) est connectée, et
le cinquième motif de câblage (50) comprend une partie d'extension qui s'étend dans une direction dans laquelle le premier motif de câblage de détection de température (93) est disposé.

4. Module à semi-conducteurs (900) selon l'une quelconque des revendications 1 à 3, dans lequel le deuxième motif de câblage de détection de température (94) est disposé entre le premier motif de câblage de détection de température (93) et le deuxième motif de câblage (20) ou entre le premier motif de câblage de détection de température (93) et le quatrième motif de câblage (40), et
le module à semi-conducteurs (900) comprend en outre un motif de câblage de réduction de couplage capacitif (97) disposé du côté où le deuxième motif de câblage de détection de température (94) n'est pas disposé entre le premier motif de câblage de détection de température (93) et le deuxième motif de câblage (20) et entre le premier motif de câblage de détection de température (93) et le quatrième motif de câblage (40).

5. Module à semi-conducteurs (900) selon la revendication 4, dans lequel le motif de câblage de réduction de couplage capacitif (97) est un motif qui est connecté à la masse.

6. Module à semi-conducteurs (900) selon la revendication 5, dans lequel la deuxième borne de source d'alimentation (52, 53) est une borne à connecter à la masse,
la pluralité de motifs de câblage comprend en outre un cinquième motif de câblage (50) auquel la deuxième borne de source d'alimentation (52, 53) est connectée, et
le motif de câblage de réduction de couplage capacitif (97) est connecté au cinquième motif de câblage (50).
